(19) **Europäisches Patentamt**
**European Patent Office**
**Office européen des brevets**

(11) **EP 1 975 985 A1**

(12) **EUROPEAN PATENT APPLICATION**
published in accordance with Art. 158(3) EPC

(43) Date of publication:
**01.10.2008 Bulletin 2008/40**

(51) Int Cl.:
**H01L 21/304** *(2006.01)* **B24B 37/00** *(2006.01)*

(21) Application number: **07713711.5**

(22) Date of filing: **22.01.2007**

(86) International application number:
**PCT/JP2007/051315**

(87) International publication number:
**WO 2007/086529 (02.08.2007 Gazette 2007/31)**

(84) Designated Contracting States:
**DE FR IT**

(30) Priority: **25.01.2006 JP 2006015944**

(71) Applicant: **JSR Corporation**
**Tokyo 104-0045 (JP)**

(72) Inventors:
• **HOSAKA, Yukio**
**Tokyo 104-0045 (JP)**
• **TSUJI, Shoei**
**Tokyo 104-0045 (JP)**

(74) Representative: **TBK-Patent**
**Bavariaring 4-6**
**80336 München (DE)**

(54) **CHEMICAL MECHANICAL POLISHING PAD AND METHOD FOR MANUFACTURING SAME**

(57)    There is provided a chemical mechanical polishing pad which has a circular polishing surface and a non-polishing surface that is the back side of the polishing surface and incorporates an information recording medium that is readable or readable/writable by an electromagnetic wave in a noncontact manner and in which the position of the center of gravity of the information recording medium in the radial direction of the polishing surface is preferably within a range of 0 to 10% or 80 to 100% of the radius of the polishing surface in the direction from the center on the radius of the polishing surface toward the periphery of the polishing surface.

EP 1 975 985 A1

## Description

Field of the Invention

The present invention relates to a chemical mechanical polishing pad and a method for producing the same.

Background Art

In formation of a semiconductor device, chemical mechanical polishing (generally abbreviated as "CMP") has been widely employed as a polishing method by which a surface having excellent flatness can be formed on a silicon substrate or a silicon substrate having wires, electrodes and other components formed thereon (hereinafter, these silicon substrates may be collectively referred to as "semiconductor wafers"). About this chemical mechanical polishing, it is known that the result of polishing is greatly affected by the characteristics and properties of chemical mechanical polishing pad, and a variety of chemical mechanical polishing pads have heretofore been proposed.

JP-ANos. 11-70463 and 8-216029 propose a chemical mechanical polishing method which uses a polyurethane foam containing a number of fine holes as a chemical mechanical polishing pad and carries out polishing with an aqueous dispersion for chemical mechanical polishing kept in the holes (hereinafter also referred to as "pores") opened on the surface of the pad.

Further, JP-A Nos. 8-500622 and 2000-34416 propose a polishing pad having a water-soluble polymer dispersed in a matrix resin. In this polishing pad, the water-soluble polymer dissolves or swells by contacting an aqueous dispersion for chemical mechanical polishing at the time of polishing and thereby detaches from the pad, and the resulting spaces have a function of retaining the aqueous dispersion for chemical mechanical polishing.

Meanwhile, in the case of chemical mechanical polishing pads, there are cases where one needs to know information specific to the polishing pads, such as model numbers, production numbers, production records, actual measurement values of the actual sizes and physical properties of the products (i.e. individual characteristics of individual products within allowable error ranges of product characteristics specified by the model numbers) and usage records, for the purpose of managements of manufacturing, delivery, distribution and maintenance.

As a method of attaching the specific information to individual products, it has been practiced to print a bar code directly on a packaging material for the chemical mechanical polishing pad or attach a sticker having the bar code printed thereon to the packaging material. However, the amount of information that can be held in the bar code is limited, and there is also a problem that it is complicated to manage correspondence between a chemical mechanical polishing pad and a bar code attached on a packaging material after the packaging material is opened once and the chemical mechanical polishing pad has started to be used. Accordingly, there is a growing demand for implantation of an information recording medium (generally referred to as "IC tag", "electronic tag", "RFID (Radio Frequency IDentification)" or the like) which is readable or readable/writable by an electromagnetic wave in a noncontact manner.

However, in the chemical mechanical polishing pad whose characteristics and properties greatly affect the result of polishing, the presence of the information recording medium which is a foreign object on the front or rear face of the pad or inside the pad has an undesirable effect on polishing performance. For example, it causes poor uniformity of polished surface, and scratches and erosion which degrade surface flatness occur. Further, unavoidable distortion of the pad itself which occurs when the pad is attached to a polishing apparatus may damage the information recording medium itself.

Due to technical progress in recent years, a reduction in the size of such an information recording medium has been promoted. However, since there is a limitation of frequencies which are easy to use in a chemical mechanical polishing process with respect to the electromagnetic wave to be used for reading or reading/writing, an antenna which should be provided in the information recording medium must have at least a given size, and a reduction in size of the information recording medium to be embedded in the chemical mechanical polishing pad is limited. Consequently, it is conceived that the problem of degradation in the polishing performance of a pad having the information recording medium embedded therein cannot be solved by a reduction in the size of the medium.

Disclosure of the Invention

The present invention has been conceived in view of the above circumstances. An object of the present invention is to provide a chemical mechanical polishing pad that has an information recording medium which is readable or readable/writable by an electromagnetic wave in a noncontact manner and exerts excellent polishing performance, i.e. achieves excellent uniformity and surface flatness of polished surface by inhibiting the occurrence of scratches and erosion, and a production method of the chemical mechanical polishing pad.

According to the present invention, firstly, the above object of the present invention is achieved by a chemical mechanical polishing pad having a circular polishing surface and a non-polishing surface which is the back side of the polishing surface and incorporating an information recording medium which is readable or readable/writable by an electromagnetic wave in a noncontact manner.

Secondly, the above object of the present invention is achieved by a method for producing the above chemical mechanical polishing pad, comprising the following steps:

(A1) a step of preparing a composition for the chemical mechanical polishing pad,
(A2) a step of molding a rough pad form from the composition,
the rough pad form having an opening where an information recording medium is to be placed, on the surface that is to be the non-polishing surface of the pad,
(A3) a step of placing the information recording medium in the opening and filling the remaining space in the opening with the composition for the chemical mechanical polishing pad, and
(A4) a step of heating the rough pad form to a temperature of 150 to 180°C under a pressure of 1 to 20 MPa.

Thirdly, the above object of the present invention is achieved by a method for producing the above chemical mechanical polishing pad, comprising the following steps:

(B1) a step of preparing a composition for the chemical mechanical polishing pad,
(B2) a step of molding a rough pad form from the composition,
the rough pad form having an opening where an information recording medium is to be placed, on the surface that is to be the non-polishing surface of the pad, and
(B3) a step of attaching the information recording medium to the opening.

Best Mode for Carrying out the Invention

The chemical mechanical polishing pad of the present invention has a circular polishing surface and a non-polishing surface which is the back side of the polishing surface. The pad of the present invention preferably has a disk shape (right cylindrical shape) or a shape based on the disk shape. The present pad may have a side face which defines the polishing surface and the non-polishing surface or may have no distinct side face and have gradually decreased thickness in the most peripheral area of the pad.

The polishing pad of the present invention has a diameter of the polishing surface of preferably 150 to 1,200 mm, more preferably 500 to 800 mm and has a thickness of preferably 1.0 to 5.0 mm, more preferably 1.5 to 3.0 mm.

The chemical mechanical polishing pad of the present invention may have a groove or other hollow of any shape on the polishing surface. Illustrative examples of the shape of the groove include concentric grooves, a spiral groove, lattice-shaped grooves, radial grooves, and grooves resulting from combining any of these grooves. The shape of a cross section in the width direction, i.e. normal direction of the groove is not particularly limited. For example, the cross section may have a polygonal shape formed by flat side faces and, in some cases, the flat bottom surface, or a horseshoe shape. The shape of the cross section may be bilaterally axisymmetric or non-axisymmetric. Illustrative examples of the shape of the above other hollow include a circular hollow and a polygonal hollow. It is to be understood that in the above circular hollow and polygonal hollow, its inside surrounded by the circle or the polygon is also hollow.

The chemical mechanical polishing pad of the present invention may have a groove or other hollow of any shape on the non-polishing surface. By the presence of such a groove or other hollow, the occurrence of scratches on an object to be polished can be further suppressed. The shape of the groove or other hollow which may be formed on the non-polishing surface is the same as the shape of the above groove or other hollow which may be formed on the polishing surface. It is preferred that the groove or other hollow on the non-polishing surface do not reach the periphery of the pad.

The above other hollow (especially a circular hollow or polygonal hollow) which may be formed on the non-polishing surface is preferably positioned in the center of the non-polishing surface. The phrase "positioned in the center" not only indicates that these hollows are positioned in the center of the non-polishing surface in a mathematically strict sense but also indicates that the center of the non-polishing surface of the pad is positioned within the range of the above hollow. When the shape of the hollow on the non-polishing surface is circular, the upper limit of its diameter is preferably 100%, more preferably 75%, much more preferably 50% of the maximum diameter of an object to be polished (for instance, the diameter of a disk-shaped semiconductor wafer when the object to be polished is the wafer). When the shape of the hollow on the non-polishing surface is circular, the lower limit of its diameter is preferably 2 mm, more preferably 10 mm, regardless of the size of the object to be polished. For example, when the diameter of the wafer which is the object to be polished is 300 mm, the diameter when the hollow on the non-polishing surface is circular is preferably 2 to 300 mm, more preferably 10 to 225 mm, much more preferably 10 to 150 mm. Further, when the diameter of the wafer which is the object to be polished is 200 mm, the diameter when the hollow on the non-polishing surface is circular is preferably 2 to 200 mm, more preferably 10 to 150 mm, much more preferably 10 to 100 mm.

The chemical mechanical polishing pad of the present invention may have a translucent area which optically leads from the non-polishing surface to the polishing surface. When the pad has such a translucent area, the end point of polishing can be optically detected, when the pad is attached to a chemical mechanical polishing apparatus having an optical polishing end point detector and used. The planar shape of the translucent area is not particularly limited, and the shape of the periphery of the area may be circular, oval, sectoral or polygonal. The position of the translucent area should match the position of the optical polishing end point detector provided in the chemical mechanical polishing apparatus to which the chemical mechanical polishing pad of the present invention is attached. The present pad may have one or more translucent areas. When the present pad has a plurality of translucent areas, their arrangement is not particularly limited, as long as the above positional relationship is satisfied. A method of forming the translucent area is not particularly limited. For example, the translucent area may be formed by a method comprising constituting the area to have translucency on the pad by a member having translucency, or when the pad comprises a material having a certain degree of translucency, the translucent area may be formed by a method comprising forming a hollow in a portion corresponding to the area to have translucency on the pad to thin the portion so as to secure translucency required to detect the end point of polishing. When the latter method is used, the hollow of the translucent area can also serve as the aforementioned hollow for suppressing the occurrence of scratches.

An information recording medium (hereinafter referred to as "IC tag") which is used in the present invention, i.e. an information recording medium which is readable or readable/writable by an electromagnetic wave in a noncontact manner comprises at least an IC chip (Integrated Circuit Chip) and an antenna.

The above IC chip comprises at least an information storage device (memory) and a radio circuit. The information storage device may be a read-only memory (ROM) or a readable/writable memory (RAM). The IC chip may further comprise a CPU (Central Processing Unit) and the like as required. The radio circuit is preferably communicatable in the long frequency (LF) band, very high frequency (VHF) band, ultra high frequency (UHF) band, quasi microwave band or microwave band. When information is read or read/written during the chemical mechanical polishing process which is carried out by use of the chemical mechanical polishing pad of the present invention, this radio circuit is preferably communicatable in the long frequency band or very high frequency band.

The IC tag used in the present invention may be an active type having a battery or a passive type having no battery.

To the IC tag, various measurement devices may be connected. Illustrative examples of the measurement devices include a thermometer and a pressure sensor.

The IC tag may be of any shape. However, since it must be able to house an antenna required to receive and transmit an electromagnetic wave for reading or writing in a non-contact manner and must have a shape and size which allow the IC tag to fit within the range of the thickness of the chemical mechanical polishing pad of the present invention, the IC tag is preferably in the shape of a card. The planar shape of the card may be circular, oval or polygonal. Illustrative examples of the polygonal shape include a triangle, square, rectangle and rhombus. The concept of "polygonal" as used herein includes shapes having rounded corners.

The size of the IC tag is not particularly limited. For example, when the IC tag is in the shape of a square card, a side of the square is preferably 10 to 300 mm, more preferably 10 to 50 mm. The thickness is preferably 0.1 to 4.0 mm, more preferably 0.2 to 2.5 mm.

When the IC tag is in the shape of a rectangular card, its longer side is preferably 10 to 300 mm, more preferably 10 to 200 mm. Its shorter side is preferably 3 to 200 mm, more preferably 3 to 150 mm. The preferable thickness of the IC tag in the shape of a rectangular card is the same as that of the IC tag in the shape of a square card.

The chemical mechanical polishing pad of the present invention comprises such an IC tag as described above. Although the position of the center of gravity of the IC tag in the radial direction of the polishing surface is not particularly limited, it is preferably present in a range of 0 to 10% or 80 to 100% of the radius of the polishing surface in the direction from the center on the radius of the polishing surface toward the periphery of the polishing surface. The "center of gravity of the IC tag" as used herein is center of gravity in a geometrical sense, not in a dynamic sense (same will apply to the following description). When the IC tag is in the shape of a card, the thickness direction of the IC tag is preferably parallel to the thickness direction of the pad.

When the chemical mechanical polishing pad of the present invention has a translucent area, all of the shape of the IC tag projected onto the non-polishing surface is preferably outside of the translucent area.

When the chemical mechanical polishing pad of the present invention has a hollow on its non-polishing surface (except for a case when the hollow also serves as the translucent area), a part or all of the shape of the IC tag projected onto the non-polishing surface is preferably within the range of the hollow. More preferably, all of the shape is within the range of the hollow. Much more preferably, the pad has a circular or polygonal hollow in the center of the non-polishing pad, and a part or all of the shape of the IC tag projected onto the non-polishing surface is within the range of the hollow. Particularly preferably, all of the shape is within the range of the hollow. When all of the shape of the IC tag projected onto the non-polishing surface is within the range of the hollow, the shape and size of the IC tag projected onto the non-polishing surface may match the shape and size of the hollow. Preferably, the hollow includes the shape and size of the IC tag projected onto the non-polishing surface and is larger than the size of the IC tag projected onto the non-polishing surface.

The position of the center of gravity of the IC tag in the thickness direction of the chemical mechanical polishing pad of the present invention is preferably within a range of 50 to 100% of the thickness of the pad in the direction from the polishing surface toward the non-polishing surface. That is, when a line AC which extends from a point A on the polishing surface to a point C on the non-polishing surface through the center of gravity B of the IC tag is assumed, the position of the center of gravity B of the IC tag is preferably within a range of 50 to 100% of the distance between the point A and the point C. This value is more preferably 70 to 100%, much more preferably 80 to 100%.

When a part or all of the shape of the IC tag projected onto the non-polishing surface is within the range of the hollow formed on the non-polishing surface, the depth of the hollow is preferably 0.1 to 3.0 mm, more preferably 0.2 to 2.0 mm.

Further, it is preferable that all of the IC tag be included inside the chemical mechanical polishing pad of the present invention and any part thereof be not exposed to the outside of the pad.

When the IC tag included in the chemical mechanical polishing pad of the present invention is positioned at such a position as described above, the present pad is less likely to impair the uniformity and surface flatness of polished surface upon chemical mechanical polishing and can provide a high-quality polished surface, and breakage of the IC tag during handling of the pad, e.g. attachment of the pad to a polishing apparatus, can also be prevented.

The above chemical mechanical polishing pad of the present invention can be produced by a proper method such as the following production method A or production method B.

The production method A comprises the following steps:

(A1) a step of preparing a composition for a chemical mechanical polishing pad,
(A2) a step of molding a rough pad form from the composition, the rough pad form having a surface that is to be a circular polishing surface and a surface that is to be a non-polishing surface which is the back side of the polishing surface,
the rough pad form having an opening where an IC tag is to be placed, on the surface that is to be the non-polishing surface of the pad,
(A3) a step of placing the IC tag in the opening and filling the remaining space in the opening with the composition for a chemical mechanical polishing pad, and
(A4) a step of heating the rough pad form to a temperature of 150 to 180°C under a pressure of 1 to 20 MPa.

The production method B comprises the following steps:

(B1) a step of preparing a composition for a chemical mechanical polishing pad,
(B2) a step of molding a rough pad form from the composition, the rough pad form having a surface that is to be a circular polishing surface and a surface that is to be a non-polishing surface which is the back side of the polishing surface,
the rough pad form having an opening where an IC tag is to be placed, on the surface that is to be the non-polishing surface of the pad, and
(B3) a step of attaching the IC tag to the opening.

Hereinafter, each of the steps in each of the above production methods will be described in detail.

Production Method A

(A1) Step of Preparing Composition for Chemical Mechanical Polishing Pad

Illustrative examples of the composition for a chemical mechanical polishing pad include a composition for a chemical mechanical polishing pad comprising (a) at least one selected from the group consisting of a thermoplastic resin, an elastomer, rubber and a curable resin and (b) water-soluble particles (hereinafter may be referred to as "first composition"), and a composition for a chemical mechanical polishing pad comprising (1) a polyol, (2) a polyisocyanate and (3) a foaming agent (hereinafter may be referred to as "second composition").

Illustrative examples of thermoplastic resins which can be used as the component (a) in the first composition include 1,2-polybutadiene resins; polyolefin resins such as polyethylene; polystyrene resins; polyacrylic resins such as (meth)acrylic resins; vinylester resins (excluding polyacrylic resins); polyester resins; polyamide resins; fluorine resins such as polyvinylidene fluoride; polycarbonate resins; and polyacetal resins.

Illustrative examples of the elastomer include diene elastomers such as 1,2-polybutadiene; polyolefin elastomers (TPO); styrene-based elastomers such as a styrene-butadiene-styrene block copolymer (SBS) and a hydrogenated block copolymer thereof (SEBS); thermoplastic elastomers such as thermoplastic polyurethane elastomers (TPU), thermoplastic polyester elastomers (TPEE) and polyamide elastomers (TPAE) ; silicone resin elastomers; and fluorine resin elastomers.

Illustrative examples of the rubber include conjugated diene rubbers such as butadiene rubbers (high-cis butadiene rubber, low-cis butadiene rubber, and the like), isoprene rubber, styrene-butadiene rubber, and styrene-isoprene rubber; nitrile rubbers such as acrylonitrile-butadiene rubber; acrylic rubbers; ethylene-$\alpha$-olefin rubbers such as ethylene-propylene rubber and ethylene-propylene-diene rubber; and other rubbers such as butyl rubber, silicone rubber and fluorine-containing rubber.

The curable resin may be either a thermosetting resin or a light curable resin. Illustrative examples thereof include urethane resins, epoxy resins, acrylic resins, unsaturated polyester resins, polyurethane-urea resins, urea resins, silicon resins, phenolic resins, and vinylester resins.

The above component (a) may be partially or wholly modified with an acid anhydride group, carboxyl group, hydroxyl group, epoxy group, amino group or the like.

Of those described above, the rubber, curable resin, thermoplastic resin or elastomer is preferably used as the component (a). The thermoplastic resin or elastomer is more preferred, and 1,2-polybutadiene is particularly preferred. The component (a) may be a partially crosslinked polymer. Crosslinking can be carried out by, for example, chemical crosslinking using an organic peroxide, sulfur, a sulfur compound or the like or radiation crosslinking involving electron irradiation.

Illustrative examples of a material which constitutes the water-soluble particles (b) in the first composition include sugars (e.g. polysaccharides such as starch, dextrin and cyclodextrin, lactose, mannitol), celluloses (e.g. hydroxypropylcellulose and methylcellulose), proteins, polyvinyl alcohol, polyvinyl pyrrolidone, polyacrylic acid, polyethylene oxide, water-soluble photosensitive resins, sulfonated polyisoprene, and sulfonated polyisoprene copolymers. Illustrative examples of a material for inorganic water-soluble particles include potassium sulfate, potassium nitrate, potassium carbonate, potassium bicarbonate, potassium chloride, potassium bromide, potassium phosphate, and magnesium nitrate. The above materials for these water-soluble particles may be used alone or in combination of two or more. Further, the water-soluble particles may be water-soluble particles comprising a predetermined material or two or more water-soluble particles comprising different materials.

The water-soluble particles are preferably such that they dissolve in water only when exposed to the surface layer in the polishing pad and do not absorb water and swell inside the polishing pad. To this end, the water-soluble particle may have an outer shell for inhibiting moisture absorption at least in a portion of the outermost part thereof. This outer shell may be physically adsorbed to and/or chemically bonded to the water-soluble particle. Illustrative examples of a material which constitutes such an outer shell include an epoxy resin, polyimide, polyamide and polysilicate. In this case, the water-soluble particles may comprise water-soluble particles having the outer shell and water-soluble particles having no outer shell, and the above effect can be attained to a sufficient extent even if the entire surface of the water-soluble particle having the outer shell is not covered with the outer shell.

The average particle diameter of the water-soluble particles is preferably 0.1 to 500 $\mu$m, more preferably 0.5 to 100 $\mu$m. The size of pores is preferably 0.1 to 500 $\mu$m, more preferably 0.5 to 100 $\mu$m. When the average particle diameter of the water-soluble particles is less than 0.1 $\mu$m, the size of the pores formed becomes smaller than that of abrasive grains used, so that a polishing pad which can retain slurry sufficiently becomes liable to be difficult to obtain. Meanwhile, when the average particle diameter is larger than 500 $\mu$m, the size of the pores formed becomes so large that the mechanical strength and polishing rate of the polishing pad obtained are liable to deteriorate.

The content of the water-soluble particles (b) is preferably 2 to 90% by volume, more preferably 2 to 60% by volume, much more preferably 2 to 40% by volume, when the total of the component (a) and the water-soluble particles (b) is 100% by volume. With the content of the water-soluble particles (b) within the above range, a good balance can be achieved between the polishing rate of the polishing pad obtained and the proper hardness and mechanical strength thereof.

The first composition can further comprise (c) a crosslinking agent. Illustrative examples of the crosslinking agent (c) include an organic peroxide, sulfur, and a sulfur compound. Of these, the organic peroxide is preferably used. Illustrative example of the organic peroxide include dicumyl peroxide, diethyl peroxide, di-t-butyl peroxide, diacetyl peroxide and diacyl peroxide. The crosslinking agent is used in an amount of preferably 0.01 to 5.0 parts by weight, more preferably 0.2 to 4.0 parts by weight, based on 100 parts by weight of crosslinkable polymers used as the component (a). When the crosslinking agent (c) is used in the above amount, a polishing pad which produces few scratches in a chemical mechanical polishing process and has a high polishing rate can be obtained.

Illustrative examples of the polyol (1) in the second composition include a polyhydric alcohol, polyether polyol, and polyester polyol. Specific examples of the above polyhydric alcohol include ethylene glycol, diethylene glycol, propylene glycol, dipropylene glycol, glycerin, trimethylolpropane, diethanolamine, triethanolamine, and pentaerythritol. The above polyester polyol can be suitably produced by reacting a polycarboxylic acid or a derivative thereof with a polyhydroxyl compound.

Illustrative examples of the polyisocyanate (2) include 2,4-toluylene diisocyanate, 2,6-toluylene diisocyanate, and polyphenyl polymethylene polyisocyanate. These polyisocyanates may partially or wholly contain a carboimide group, urethane group, isocyanurate group or the like. The polyisocyanate (2) is used in an amount of preferably 0.9 to 1. 4 equivalents, more preferably 0.95 to 1.3 equivalents, in terms of the amount of isocyanate groups per equivalent of hydroxyl groups contained in the polyol (1).

Illustrative examples of the foaming agent (3) include water and freon. The foaming agent (3) is used in an amount of preferably 4 to 10 parts by weight based on 100 parts by weight of the polyol (1).

The second composition can further comprise (4) a catalyst, in addition to the above components. Illustrative examples of the catalyst (4) include an amine compound and an organometallic compound. Specific examples of the amine compound include triethylene diamine, triethylamine, tetramethyl hexamethylenediamine, pentamethyl diethylenetriamine, and dimethyl cyclohexylamine. Specific examples of the organometallic compound include stannous chloride, and dibutyltin laurate. The catalyst (4) is used in an amount of preferably not larger than 1 part by weight, more preferably 0.05 to 1 part by weight, much more preferably 0.05 to 0.5 parts by weight, based on 100 parts by weight of the polyol (1).

The second composition may also comprise a foaming adjuster, other resins, a flame retardant, a surfactant or the like, in addition to the above components.

A method for preparing the above composition for a chemical mechanical polishing pad is not particularly limited. For example, the composition can be obtained by kneading the predetermined materials in a mixing device or the like. Illustrative examples of the mixing device include a roll, kneader, Banbury mixer, and extruder (single-screw or multi-screw).

When the composition for a chemical mechanical polishing pad is the first composition, the water-soluble particles are preferably solid at the time of kneading. By kneading the component (a) with the water-soluble particles (b) which have been classified to fall within the above preferred average particle diameter range in advance under conditions where the water-soluble particles (b) are solid, the water-soluble particles (b) can be dispersed with the above preferred average particle diameter, regardless of the degree of compatibility between the water-soluble particles (b) and the component (a). Therefore, according to the processing temperature of the component (a) used, water-soluble particles (b) having a melting point higher than the processing temperature are preferably selected.

(A2) Step of Molding Rough Pad Form Having Surface That Is to Be Circular Polishing Surface and Surface That Is to Be Non-Polishing Surface Which Is the Back Side of the Polishing Surface and Having Opening Where IC Tag Is to Be Placed on the Surface That Is to Be the Non-Polishing Surface of the Pad, from the Composition

To mold a rough pad form from the above composition for a chemical mechanical polishing pad, a method comprising molding the rough pad form by use of a mold having a shape that corresponds to a desired rough pad form or a method comprising molding the composition into a sheet and punching a desired rough form out of the sheet can be employed, for example. The opening where an IC tag is to be placed can be formed on the surface that is to be the non-polishing surface of the pad by use of a mold having a projection which corresponds to the opening or by a method comprising molding the shape having no opening and then forming the opening by cutting, in the case of the above molding method. Meanwhile, when the method involving sheet molding is employed, the opening may be formed by cutting after the shape is punched out.

The shape and size of the opening on the surface that is to be the non-polishing surface may match the shape and size of the IC tag projected onto the non-polishing surface when the IC tag is used in the pad. However, they may not necessarily have to match each other. The opening may be of any shape and size, as long as the IC tag to be used can be housed in the opening in the direction in which the IC tag is to be used in the next step (A3). However, it is preferable that the shape of the opening be nearly the same as the shape of the IC tag projected onto the non-polishing surface when the IC tag is used in the pad and that the size in the radial direction and size in the tangential direction of the pad be about 0.1 to 5.0 mm larger than the IC tag.

When the chemical mechanical polishing pad of the present invention has a hollow on its non-polishing surface, all of the shape of the IC tag projected onto the non-polishing surface is within the range of the hollow and the size of the hollow on the non-polishing surface is significantly larger than the size of the IC tag projected onto the non-polishing surface, an opening that is to be the hollow may be formed on the non-polishing surface and an opening in which the IC tag is to be housed may be further formed in a portion of a surface that is to be the bottom surface of the hollow. Such a two-level opening may be formed by molding the rough pad form by use of a mold having a two-level projection which corresponds to a desired opening shape or by molding a rough form having no opening and then subjecting the rough form to two-level cutting. It is also possible that a rough form is molded by use of a mold having a one-level projection and then the opening for the IC tag is formed by cutting.

(A3) Step of Placing the IC Tag in the Opening and Filling the Remaining Space in the Opening with the Composition for Chemical Mechanical Polishing Pad

Then, the IC tag is placed in the opening formed as described above in a desired direction, and the above composition for a chemical mechanical polishing pad is filled in the remaining space. The composition for a chemical mechanical polishing pad used for this purpose is preferably the same as that used for molding the rough pad form.

(A4) Step of Heating the Rough Pad Form to Temperature of 150 to 180°C under Pressure of 1 to 20 MPa

Then, the rough pad form is heated to a temperature of 150 to 180°C under a pressure of 1 to 20 MPa to embed the IC tag in the pad. The pressure applied here is preferably 1 to 18 MPa, more preferably 2 to 15 MPa. Further, the heating temperature is preferably 160 to 180°C. The heating time is preferably 1 to 60 minutes, more preferably 10 to 30 minutes. The step (A4) is preferably carried out in a mold.

Throughout the step (A3) and the step (A4), the IC tag and the rough pad form are subjected to neither a pressure of higher than 20 MPa nor a temperature of higher than 180°C. By processing the rough pad form under such pressure and temperature conditions, the function of the IC tag is not impaired, and the IC tag can suitably serve as a non-contact information recording medium.

The chemical mechanical polishing pad of the present invention can be produced in the manner as described above. When the pad of the present invention has a groove or other hollow on one or both of the polishing surface and the non-polishing surface, the groove or other hollow can be formed by using a mold having a projection which corresponds to the shape of a desired groove or other hollow in the above step (A2) or by performing proper cutting after the above step (A4).

Production Method B

(B1) Step of Preparing Composition for Chemical Mechanical Polishing Pad

In the production method B, all steps after the IC tag is placed in the rough pad form may be carried out under normal pressure at low temperatures ranging from room temperature to lower than 180°C. Accordingly, as a composition for a chemical mechanical polishing pad which is used in the step (B1), the same composition as that used in the above step (A1) can be used, and it can also be preferably used for composition required to be processed at high temperatures exceeding 180°C. (B2) Step of Molding Rough Pad Form Having Surface That Is to Be Circular Polishing Surface and Surface That Is to Be Non-Polishing Surface Which Is the Back Side of the Polishing Surface and Having Opening Where IC Tag Is to Be Placed on the Surface That Is to Be the Non-Polishing Surface of the Pad, from the Composition

The step (B2) is nearly the same as the above step (A2).

However, it is preferable that the shape and size of the opening be nearly the same as the shape and size of the IC tag projected onto the non-polishing surface when the IC tag is placed in the pad and be a shape and size which make at least a large portion of the side face of the IC tag adhere closely to the side face of the opening.

The depth of the opening is preferably nearly the same as or deeper than the distance to be occupied by the IC tag in the pad thickness direction in the pad.

When the chemical mechanical polishing pad of the present invention has a hollow on its non-polishing surface, all of the shape of the IC tag projected onto the non-polishing surface is within the range of the hollow and the size of the hollow on the non-polishing surface is significantly larger than the size of the IC tag projected onto the non-polishing surface, an opening that is to be the hollow may be formed on the non-polishing surface and an opening in which the IC tag is to be housed may be further formed in a portion of a surface that is to be the bottom surface of the hollow. Such a two-level opening can be formed in the same manner as described in the step (A2) of the production method A.

(B3) Step of Attaching the IC Tag to the Opening.

Then, after an adhesive layer is formed on at least one of the formed opening and the IC tag, the IC tag is placed and attached in the opening in a given direction. Illustrative examples of a method of forming the adhesive layer include a method of applying an adhesive and a method of applying a double-stick tape. The method of applying a double-stick tape is preferred.

The adhesive strength of the double-stick tape is preferably 100 to 3,000 g/25 mm, more preferably 500 to 2,000 g/25 mm, as strength measured in accordance with a method specified in JIS Z1528. Both surfaces of the double-stick tape may have the same adhesive strength or different adhesive strengths. In both cases, the double-stick tape can be preferably used.

When the chemical mechanical polishing pad of the present invention has a groove or other hollow on one or both of the polishing surface and the non-polishing surface, the groove or other hollow can be formed by using a mold having a projection which corresponds to the shape of a desired groove or other hollow in the above step (B2) or by performing proper cutting after the above step (B2) or (B3).

The chemical mechanical polishing pad of the present invention may be a single-layer pad which is the pad produced as described above or a double-layer pad having a support layer on the non-polishing surface. The above support layer is a layer which supports the chemical mechanical polishing pad from the back side of the polishing surface. Although the characteristics of the support layer are not particularly limited, the support layer is preferably softer than the pad itself. The support layer may be a porous body (foam) or a nonporous body. Further, its planar shape may be circular or polygonal, for example. The support layer preferably has the same planar shape and size as those of the polishing pad. Although its thickness is also not particularly limited, it is preferably 0.1 to 5 mm, more preferably 0.5 to 2 mm.

A material constituting the support layer is not particularly limited. However, an organic material is preferably used, because it can be easily molded into a given shape and characteristic and can impart moderate elasticity. As the organic material, those enumerated as examples of the component (a) of the first composition in the above step (A1) can be used.

To form the support layer on the non-polishing surface, a double-stick tape or a proper method such as lamination may be employed.

The chemical mechanical polishing pad of the present invention can be attached to a known polishing apparatus and used in a chemical mechanical polishing process in accordance with a known method. In addition, various information can be recorded in the IC tag incorporated in the pad and can be used according to need. Illustrative examples of the information to be recorded in the IC tag include the model number, production number and production record of the chemical mechanical polishing pad, and the results of quality examination on the actual size, physical properties and shape of the product. Further, when the information storage device incorporated in the IC tag is a RAM, usage records after the start of use of the pad may be recorded in turn.

The chemical mechanical polishing pad of the present invention achieves excellent uniformity and surface flatness of polished surface and exerts an excellent function as a chemical mechanical polishing pad, as exemplified by providing a high-quality polished surface. In addition, information recorded in the IC tag as described above can be read out according to need and used for managements of manufacturing, delivery, distribution and maintenance and setting of optimum polishing conditions which reflect the individual characteristics of each product. Further, when various measurement devices are connected to the IC tag, the information can be used for fine adjustments of polishing conditions to be adapted to the specific environment to which the pad in the chemical mechanical polishing process is being exposed.

Examples

Example 1

(1) Production of Chemical Mechanical Polishing Pad

(1-1) Preparation of Composition for Chemical Mechanical Polishing Pad

80 parts by volume (corresponding to 72.2 parts by weight) of 1,2-polybutadiene (product of JSR Corporation, trade name "JSR RB830") and 20 parts by volume (corresponding to 27.2 parts by weight) of β-cyclodextrin (product of Bio Research Corporation of Yokohama, trade name "DEXIPAL β-100", average particle diameter: 20 μm) were kneaded at 60 rpm for 2 minutes by an extruder adjusted to 160°C. Then, 0.6 parts by weight (corresponding to 0.33 parts by weight in terms of the amount of dicumyl peroxide per 100 parts by weight of 1,2-polybutadiene) of "PERCUMYL D40" (trade name, product of NOF Corporation, containing 40 wt% of dicumyl peroxide) was added, and the resulting mixture was kneaded at 120°C and 60 rpm for 2 minutes to obtain pellets of a composition for a chemical mechanical polishing pad.

(1-2) Production of Rough Pad Form Having Opening

The pellets were heated at 160°C for 5 minutes in a mold having a circular projection (diameter: 75 mm, height: 1.2 mm) in the center of the lower plate and crosslinked to obtain a disk-shaped molded article having a diameter of 600 mm and a thickness of 2.5 mm and having an opening in the center of a surface that was to be a back surface (non-polishing surface).

(1-3) Production of Rough Pad Form

The thus produced disk-shaped molded article was placed in a mold having no projection inside with the opening facing up. In the center of the bottom surface of the opening, a commercially available IC tag (shape: nearly square card, size: 50 mm x 50 mm x 0.2 mm, operating frequency: 13.5 MHz, material of the outer surface of the card: ABS resin, memory capacity: 512 bits, 512 bits of data was written in the memory in advance) was placed with one of its surfaces having a size of 50 mm x 50 mm contacting the bottom surface of the opening, the pellets prepared in the above (1-1) were filled in the remaining space of the opening, and the mold was closed.

Then, the mold was heated at 14 MPa and 170°C for 18 minutes, resulting in a disk-shaped rough pad form having a diameter of 600 mm and a thickness of 2.5 mm. (1-4) Production of Chemical Mechanical Polishing Pad

Then, on the polishing surface of the above molded article, concentric grooves (having a rectangular cross section) having a width of 0.5 mm, a pitch of 2.0 mm and a depth of 1.0 mm were formed by means of a commercially available cutting machine.

Further, in the center of the non-polishing surface of the molded article, a circular hollow having a diameter of 75 mm and a depth of 0.6 mm was formed by means of a commercially available cutting machine to obtain a chemical mechanical polishing pad. The position of the center of gravity of the IC tag contained in this chemical mechanical polishing pad is the center of the polishing surface in the radial direction of the polishing surface and is a position corresponding to 56% of the thickness of the pad in the pad thickness direction in the direction from the polishing surface toward the non-polishing surface. Further, this chemical mechanical polishing pad has a circular hollow in the center of the non-polishing surface and has all of the shape of the IC tag projected onto the non-polishing surface within the range of the hollow.

(2) Evaluation of Function of IC Tag

When the reading part of a commercially available reader/writer for an IC tag (output: 0.1 W) was brought close to a position that was 5 cm away from the hollow in the center of the non-polishing surface of the chemical mechanical polishing pad produced above to check whether the data could be read, it was confirmed that the prerecorded 512-bit data was intact.

(3) Evaluation of Polishing Performance

The chemical mechanical polishing pad produced above was mounted on the platen of chemical mechanical polishing apparatus "EPO112" (product of Ebara Corporation), and chemical mechanical polishing was conducted on a wafer having a diameter of 200 mm and having a patternless PETEOS film (silicon oxide film produced by plasma-enhanced chemical vapor deposition using tetraethyl orthosilicate as a raw material) on the surface thereof under the following conditions.

Aqueous Dispersion for Chemical Mechanical Polishing: CMS-1101 (trade name, product of JSR Corporation, containing silica as abrasive grains) diluted to three times with ion exchange water.

Aqueous Dispersion Feed Rate: 200 ml/min
Number of Revolutions of Surface Plate: 70 rpm
Number of Revolutions of Head: 63 rpm
Head Pressing Pressure: 4 psi
Polishing Time: 2 minutes

In the above chemical mechanical polishing, the polishing rate was 200 nm/min, the in-plane uniformity of polishing amount was 1.2%, and the number of scratches was 3 across the whole surface of the wafer.

The above polishing rate, in-plane uniformity of polishing amount and number of scratches were measured in the following manner.

The film thickness before and after polishing was measured by an optical film thickness meter at 49 points that were located at intervals of 3.75 mm in the diameter direction, the outermost points thereamong being located at 10 mm inside from the edge of the wafer, the average of differences in the film thickness between before and after polishing at these 49 points was taken as the polishing rate, and the in-plane uniformity was calculated in accordance with the following expression based on the differences in the film thickness at these 49 points.

$$\text{In-Plane Uniformity (\%)} = (\text{Standard Deviation of Film Thickness Differences}) \div (\text{Average of Film Thickness Differences}) \times 100$$

Further, the number of scratches was determined by counting the total number of produced scratches on the whole polished surface of the wafer by means of a wafer defect inspection device (product of KLA-Tencor Corporation, type "KLA2351", threshold was set at 100).

Example 2

(1) Production of Chemical Mechanical Polishing Pad

(1-1) Preparation of Composition for Chemical Mechanical Polishing Pad

Pellets of a composition for a chemical mechanical polishing pad were obtained in the same manner as in "(1-1) Preparation of Composition for Chemical Mechanical Polishing Pad" of Example 1.

(1-2) Production of Rough Pad Form Having Opening

The pellets were heated at 170°C for 18 minutes in a mold having a circular projection (diameter: 75 mm, height: 1.2 mm) in the center of the lower plate and crosslinked to obtain a disk-shaped molded article having a diameter of 600 mm and a thickness of 2.5 mm and having an opening in the center of a surface that was to be a back surface (non-polishing surface).

(1-3) Application of IC Tag to Opening

A double-stick tape (product of Nitto Denko Corporation, product name "No. 500", adhesive strength: 1, 550 g/25 mm on both sides) cut in a rectangular shape of 70 mm x 4.8 mm was applied such that the center of gravity of the rectangle matched the center of the above opening.
Then, a commercially available IC tag (shape: nearly rectangular card, size: 70 mm x 4.8 mm x 0.2 mm, operating frequency: 2.45 GHz, memory capacity: 128 byte, 110 byte of data was written in the memory in advance) was attached such that one of its surfaces having a size of 70 mm x 4.8 mm matched the rectangle of the above double-stick tape.

(1-4) Production of Chemical Mechanical Polishing Pad

Then, on the polishing surface of the above molded article, concentric grooves (having a rectangular cross section) having a width of 0.5 mm, a pitch of 2.0 mm and a depth of 1.0 mm were formed by means of a commercially available cutting machine so as to produce a chemical mechanical polishing pad. The position of the center of gravity of the IC tag contained in this chemical mechanical polishing pad is the center of the polishing surface in the radial direction of the polishing surface and is a position corresponding to 64% of the thickness of the pad in the pad thickness direction in the direction from the polishing surface toward the non-polishing surface. Further, this chemical mechanical polishing pad has a circular hollow in the center of the non-polishing surface and has all of the shape of the IC tag projected onto the non-polishing surface within the range of the hollow.

(2) Evaluation of Function of IC Tag

When the reading part of a commercially available reader/writer for an IC tag (output: 0.1 W) was brought close to a position that was 5 cm away from the hollow in the center of the non-polishing surface of the chemical mechanical polishing pad produced above to check whether the data could be read, it was confirmed that the prerecorded 110-byte data was intact.

(3) Evaluation of Polishing Performance

Chemical mechanical polishing performance was evaluated in the same manner as in Example 1 except that the above produced chemical mechanical polishing pad was used. As a result, the polishing rate was 210 nm/min, the in-plane uniformity of polishing amount was 1.5%, and the number of scratches was 5 across the whole surface of the wafer.

Example 3

(1) Production of Chemical Mechanical Polishing Pad

(1-1) Preparation of Composition for Chemical Mechanical Polishing Pad

Pellets of a composition for a chemical mechanical polishing pad were obtained in the same manner as in "(1-1) Preparation of Composition for Chemical Mechanical Polishing Pad" of Example 1.

(1-2) Production of Rough Pad Form Having Opening

The pellets were heated at 170°C for 18 minutes in a mold having a cylindrical metallic block (diameter: 75 mm, height: 0.6 mm) placed on the lower plate with the center of the block located at a point which was 540 mm from the center of the lower plate and crosslinked to obtain a disk-shaped molded article having a diameter of 600 mm and a thickness of 2.5 mm and having an opening in the center of a surface that was to be a back surface (non-polishing surface).

(1-3) Production of Rough Pad Form

The thus produced disk-shaped molded article was placed in a mold having no metallic block inside with the opening facing up. In the center of the bottom surface of the opening, a commercially available IC tag (shape: nearly square card, size: 50 mm x 50 mm x 0.2 mm, operating frequency: 13.5 MHz, material of the outer surface of the card: ABS resin, memory capacity: 512 bits, 512 bits of data was written in the memory in advance) was placed with one of its surfaces having a size of 50 mm x 50 mm contacting the bottom surface of the opening such that a 50-mm side of the IC tag became parallel to the tangential direction of the non-polishing surface, the pellets prepared in the above (1-1) were filled in the remaining space of the opening, and the mold was closed.
Then, the mold was heated at 14 MPa and 170°C for 18 minutes, resulting in a disk-shaped rough pad form having a diameter of 600 mm and a thickness of 2.5 mm. (1-4) Production of Chemical Mechanical Polishing Pad
Then, on the polishing surface of the above molded article, concentric grooves (having a rectangular cross section) having a width of 0.5 mm, a pitch of 2.0 mm and a depth of 1.0 mm were formed by means of a commercially available cutting machine to obtain a chemical mechanical polishing pad. The position of the center of gravity of the IC tag contained in this chemical mechanical polishing pad is a position corresponding to 90% in the direction from the center of the polishing surface toward its periphery in the radial direction of the polishing surface and is a position corresponding to 80% of the thickness of the pad in the pad thickness direction in the direction from the polishing surface toward the non-polishing surface.

(2) Evaluation of Function of IC Tag

When the reading part of a commercially available reader/writer for an IC tag (output: 0.1 W) was brought close to a position that was 5 cm away from the hollow in the center of the non-polishing surface of the chemical mechanical polishing pad produced above to check whether the data could be read, it was confirmed that the prerecorded 512-bit data was intact.

(3) Evaluation of Polishing Performance

Chemical mechanical polishing performance was evaluated in the same manner as in Example 1 except that the above produced chemical mechanical polishing pad was used. As a result, the polishing rate was 210 nm/min, the in-plane uniformity of polishing amount was 1.2%, and the number of scratches was 3 across the whole surface of the wafer.

Example 4

(1) Production of Chemical Mechanical Polishing Pad

(1-1) Preparation of Composition for Chemical Mechanical Polishing Pad

Pellets of a composition for a chemical mechanical polishing pad were obtained in the same manner as in "(1-1) Preparation of Composition for Chemical Mechanical Polishing Pad" of Example 1.

(1-2) Production of Rough Pad Form Having Opening

The pellets were heated at 170°C for 18 minutes in a mold having a cylindrical metallic block (diameter: 75 mm, height: 1.1 mm) placed on the lower plate with the center of the block located at a point which was 48 mm from the center of the lower plate and crosslinked to obtain a disk-shaped molded article having a diameter of 600 mm and a thickness of 2.5 mm and having an opening in the center of a surface that was to be a back surface (non-polishing surface).

(1-3) Production of Rough Pad Form

The thus produced disk-shaped molded article was placed in a mold having no metallic block inside with the opening facing up. In the center of the bottom surface of the opening, a commercially available IC tag (shape: nearly square card, size: 50 mm x 50 mm x 0.2 mm, operating frequency: 13.5 MHz, material of the outer surface of the card: ABS resin, memory capacity: 512 bits, 512 bits of data was written in the memory in advance) was placed with one of its surfaces having a size of 50 mm x 50 mm contacting the bottom surface of the opening such that a 50-mm side of the IC tag became parallel to the tangential direction of the non-polishing surface, the pellets prepared in the above (1-1) were filled in the remaining space of the opening, and the mold was closed.

Then, the mold was heated at 14 MPa and 170°C for 18 minutes, resulting in a disk-shaped rough pad form having a diameter of 600 mm and a thickness of 2.5 mm. (1-4) Production of Chemical Mechanical Polishing Pad

Then, on the polishing surface of the above molded article, concentric grooves (having a rectangular cross section) having a width of 0.5 mm, a pitch of 2.0 mm and a depth of 1.0 mm were formed by means of a commercially available cutting machine.

Further, by means of a commercially available cutting machine, a circular hollow having a diameter of 75 mm and a depth of 0.6 mm was formed such that the center of the hollow was located at a point which was 48 mm from the center of the non-polishing surface of the molded article to obtain a chemical mechanical polishing pad. The position of the center of gravity of the IC tag contained in this chemical mechanical polishing pad is a position corresponding to 8% in the direction from the center of the polishing surface toward its periphery in the radial direction of the polishing surface and is a position corresponding to 60% of the thickness of the pad in the pad thickness direction in the direction from the polishing surface toward the non-polishing surface. Further, this chemical mechanical polishing pad has a circular hollow whose center is located at a point corresponding to 48 mm in the direction from the center of the non-polishing surface toward its periphery and has all of the shape of the above IC tag projected onto the non-polishing surface within the range of the hollow.

(2) Evaluation of Function of IC Tag

When the reading part of a commercially available reader/writer for an IC tag (output: 0.1 W) was brought close to a position that was 5 cm away from the hollow in the center of the non-polishing surface of the chemical mechanical polishing pad produced above to check whether the data could be read, it was confirmed that the prerecorded 512-bit data was intact.

(3) Evaluation of Polishing Performance

Chemical mechanical polishing performance was evaluated in the same manner as in Example 1 except that the above produced chemical mechanical polishing pad was used. As a result, the polishing rate was 190 nm/min, the in-plane uniformity of polishing amount was 1.5%, and the number of scratches was 3 across the whole surface of the wafer.

Comparative Example 1

A chemical mechanical polishing pad was produced in the same manner as in Example 1 except that the mold temperature was set at 250°C in "(1-3) Production of Rough Pad Form" in Example 1.

When the function of the IC tag was evaluated in the same manner as in Example 1, the prerecorded data could not be read.

Comparative Example 2

(1) Production of Chemical Mechanical Polishing Pad

(1-1) Preparation of Composition for Chemical Mechanical Polishing Pad

Pellets of a composition for a chemical mechanical polishing pad were obtained in the same manner as in "(1-1) Preparation of Composition for Chemical Mechanical Polishing Pad" of Example 1.

(1-2) Production of Rough Pad Form Having Opening

The pellets were heated at 170°C for 18 minutes in a mold having a cylindrical metallic block (diameter: 75 mm, height: 0.6 mm) placed on the lower plate with the center of the block located at a point which was 300 mm from the center of the lower plate and crosslinked to obtain a disk-shaped molded article having a diameter of 600 mm and a thickness of 2.5 mm and having an opening in the center of a surface that was to be a back surface (non-polishing surface).

(1-3) Production of Rough Pad Form

A disk-shaped rough pad form having a diameter of 600 mm and a thickness of 2.5 mm was obtained in the same manner as in Example 3 except that the above produced disk-shaped molded article was used.

(1-4) Production of Chemical Mechanical Polishing Pad

A chemical mechanical polishing pad was obtained in the same manner as in Example 3 except that the above produced rough pad form was used. The position of the center of gravity of the IC tag contained in this chemical mechanical polishing pad is a position corresponding to 50% in the direction from the center of the polishing surface toward its periphery in the radial direction of the polishing surface and is a position corresponding to 80% of the thickness of the pad in the pad thickness direction in the direction from the polishing surface toward the non-polishing surface.

(2) Evaluation of Function of IC Tag

When the reading part of a commercially available reader/writer for an IC tag (output: 0.1 W) was brought close to a position that was 5 cm away from the hollow in the center of the non-polishing surface of the chemical mechanical polishing pad produced above to check whether the data could be read, it was confirmed that the prerecorded 512-bit data was intact.

(3) Evaluation of Polishing Performance

Chemical mechanical polishing performance was evaluated in the same manner as in Example 1 except that the above produced chemical mechanical polishing pad was used. As a result, the polishing rate was 200 nm/min, the in-plane uniformity of polishing amount was 5.0%, and the number of scratches was 52 across the whole surface of the wafer.

Comparative Example 3

(1) Production of Chemical Mechanical Polishing Pad

(1-1) Preparation of Composition for Chemical Mechanical Polishing Pad

Pellets of a composition for a chemical mechanical polishing pad were obtained in the same manner as in "(1-1) Preparation of Composition for Chemical Mechanical Polishing Pad" of Example 1. (1-2) Production of Rough Pad Form Having Opening

The pellets were heated at 170°C for 18 minutes in a mold having a cylindrical metallic block (diameter: 75 mm, height: 1.6 mm) placed on the lower plate with the center of the block located at a point which was 120 mm from the center of the lower plate and crosslinked to obtain a disk-shaped molded article having a diameter of 600 mm and a thickness of 2.5 mm and having an opening in the center of a surface that was to be a back surface (non-polishing surface).

(1-3) Production of Rough Pad Form

A disk-shaped rough pad form having a diameter of 600 mm and a thickness of 2.5 mm was obtained in the same manner as in Example 3 except that the above produced disk-shaped molded article was used.

(1-4) Production of Chemical Mechanical Polishing Pad

Then, on the polishing surface of the above molded article, concentric grooves (having a rectangular cross section) having a width of 0.5 mm, a pitch of 2.0 mm and a depth of 1.0 mm were formed by means of a commercially available cutting machine.

Further, by means of a commercially available cutting machine, a circular hollow having a diameter of 75 mm and a depth of 1.0 mm was formed such that the center of the hollow was located at a point which was 120 mm from the center of the non-polishing surface of the molded article to obtain a chemical mechanical polishing pad. The position of the center of gravity of the IC tag contained in this chemical mechanical polishing pad is a position corresponding to 20% in the direction from the center of the polishing surface toward its periphery in the radial direction of the polishing surface and is a position corresponding to 40% of the thickness of the pad in the pad thickness direction in the direction from the polishing surface toward the non-polishing surface. Further, this chemical mechanical polishing pad has a circular hollow whose center is located at a point corresponding to 120 mm in the direction from the center of the non-polishing surface toward its periphery and has all of the shape of the above IC tag projected onto the non-polishing surface within the range of the hollow.

(2) Evaluation of Function of IC Tag

When the reading part of a commercially available reader/writer for an IC tag (output: 0.1 W) was brought close to a position that was 5 cm away from the hollow in the center of the non-polishing surface of the chemical mechanical polishing pad produced above to check whether the data could be read, it was confirmed that the prerecorded 512-bit data was intact.

(3) Evaluation of Polishing Performance

Chemical mechanical polishing performance was evaluated in the same manner as in Example 1 except that the above produced chemical mechanical polishing pad was used. As a result, the polishing rate was 190 nm/min, the in-plane uniformity of polishing amount was 4.0%, and the number of scratches was 43 across the whole surface of the wafer.

Comparative Example 4

(1) Production of Chemical Mechanical Polishing Pad

(1-1) Preparation of Composition for Chemical Mechanical Polishing Pad

Pellets of a composition for a chemical mechanical polishing pad were obtained in the same manner as in "(1-1) Preparation of Composition for Chemical Mechanical Polishing Pad" of Example 1. (1-2) Production of Rough Pad Form Having Opening

The pellets were heated at 170°C for 18 minutes in a mold having a cylindrical metallic block (diameter: 75 mm, height: 1.9 mm) placed on the lower plate with the center of the block located at a point which was 420 mm from the center of the lower plate and crosslinked to obtain a disk-shaped molded article having a diameter of 600 mm and a thickness of 2.5 mm and having an opening in the center of a surface that was to be a back surface (non-polishing surface).

(1-3) Production of Rough Pad Form

A disk-shaped rough pad form having a diameter of 600 mm and a thickness of 2.5 mm was obtained in the same manner as in Example 3 except that the above produced disk-shaped molded article was used.

(1-4) Production of Chemical Mechanical Polishing Pad

A chemical mechanical polishing pad was obtained in the same manner as in Comparative Example 3 except that the above produced rough pad form was used. The position of the center of gravity of the IC tag contained in this chemical mechanical polishing pad is a position corresponding to 70% in the direction from the center of the polishing surface toward its periphery in the radial direction of the polishing surface and is a position corresponding to 28% of the thickness of the pad in the pad thickness direction in the direction from the polishing surface toward the non-polishing surface.

(2) Evaluation of Function of IC Tag

When the reading part of a commercially available reader/writer for an IC tag (output: 0.1 W) was brought close to a position that was 5 cm away from the hollow in the center of the non-polishing surface of the chemical mechanical polishing pad produced above to check whether the data could be read, it was confirmed that the prerecorded 512-bit data was intact.

(3) Evaluation of Polishing Performance

Chemical mechanical polishing performance was evaluated in the same manner as in Example 1 except that the above produced chemical mechanical polishing pad was used. As a result, the polishing rate was 180 nm/min, the in-plane uniformity of polishing amount was 6.0%, and the number of scratches was 100 across the whole surface of the wafer.

**Claims**

1.  A chemical mechanical polishing pad having a circular polishing surface and a non-polishing surface which is the back side of the polishing surface and incorporating an information recording medium which is readable or readable/writable by an electromagnetic wave in a noncontact manner.

2.  The chemical mechanical polishing pad of claim 1, wherein the position of the center of gravity of the information recording medium in the radial direction of the polishing surface is within a range of 0 to 10% or 80 to 100% of the radius of the polishing surface in the direction from the center on the radius of the polishing surface toward the periphery of the polishing surface.

3.  The chemical mechanical polishing pad of claim 1, wherein the position of the center of gravity of the information recording medium in the thickness direction of the pad is within a range of 50 to 100% of the thickness of the pad in the direction from the polishing surface toward the non-polishing surface.

4.  The chemical mechanical polishing pad of claim 1, wherein the non-polishing surface has a hollow, and a part or all of the shape of the information recording medium projected onto the non-polishing surface is within the range of the hollow.

5.  A method for producing the chemical mechanical polishing pad of claim 1, comprising the following steps:

    (A1) a step of preparing a composition for the chemical mechanical polishing pad,
    (A2) a step of molding a rough pad form from the composition, the rough pad form having a surface that is to be a circular polishing surface and a surface that is to be a non-polishing surface which is the back side of the polishing surface,
    the rough pad form having an opening where an information recording medium is to be placed, on the surface that is to be the non-polishing surface of the pad,
    (A3) a step of placing the information recording medium in the opening and filling the remaining space in the opening with the composition for the chemical mechanical polishing pad, and
    (A4) a step of heating the rough pad form to a temperature of 150 to 180°C under a pressure of 1 to 20 MPa.

6.  A method for producing the chemical mechanical polishing pad of claim 1, comprising the following steps:

    (B1) a step of preparing a composition for the chemical mechanical polishing pad,
    (B2) a step of molding a rough pad form from the composition, the rough pad form having a surface that is to be a circular polishing surface and a surface that is to be a non-polishing surface which is the back side of the polishing surface,

the rough pad form having an opening where an information recording medium is to be placed, on the surface that is to be the non-polishing surface of the pad, and
(B3) a step of attaching the information recording medium to the opening.

7. The method of claim 5 or 6, wherein the composition for the chemical mechanical polishing pad comprises (a) at least one selected from the group consisting of a thermoplastic resin, an elastomer, rubber and a curable resin and (b) water-soluble particles.

8. The method of claim 5 or 6, wherein the composition for the chemical mechanical polishing pad comprises (1) a polyol, (2) a polyisocyanate and (3) a foaming agent.

## INTERNATIONAL SEARCH REPORT

| International application No. |
|---|
| PCT/JP2007/051315 |

A.   CLASSIFICATION OF SUBJECT MATTER
*H01L21/304*(2006.01)i, *B24B37/00*(2006.01)i

According to International Patent Classification (IPC) or to both national classification and IPC

B.   FIELDS SEARCHED

Minimum documentation searched (classification system followed by classification symbols)
H01L21/304, B24B37/00

Documentation searched other than minimum documentation to the extent that such documents are included in the fields searched
Jitsuyo Shinan Koho       1922-1996   Jitsuyo Shinan Toroku Koho   1996-2007
Kokai Jitsuyo Shinan Koho  1971-2007   Toroku Jitsuyo Shinan Koho   1994-2007

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 2003-500228 A  (3M Innovative Properties Co.), <br> 07 January, 2003 (07.01.03), <br> Par. Nos. [0008], [0070] <br> & US 6264533 B1          & WO 2000/073020 A1 | 1-8 |
| Y | JP 2000-331962 A  (Lintec Corp.), <br> 30 November, 2000 (30.11.00), <br> Par. Nos. [0003], [0004], [0026] to [0035] <br> & US 6718223 B1 | 1-8 |
| Y | JP 2003-197581 A  (Fujitsu Ltd.), <br> 11 July, 2003 (11.07.03), <br> Par. No. [0079] <br> & US 2003/0077993 A1 | 1-8 |

☒   Further documents are listed in the continuation of Box C.       ☐   See patent family annex.

| | |
|---|---|
| *      Special categories of cited documents: <br> "A"    document defining the general state of the art which is not considered    to be of particular relevance <br> "E"    earlier application or patent but published on or after the international filing date <br> "L"    document which may throw doubts on priority claim(s) or which is cited to establish the publication date of another citation or other special reason (as specified) <br> "O"    document referring to an oral disclosure, use, exhibition or other means <br> "P"    document published prior to the international filing date but later than the priority date claimed | "T"    later document published after the international filing date or priority date and not in conflict with the application but cited to understand the principle or theory underlying the invention <br> "X"    document of particular relevance; the claimed invention cannot be considered novel or cannot be considered to involve an inventive step when the document is taken alone <br> "Y"    document of particular relevance; the claimed invention cannot be considered to involve an inventive step when the document is combined with one or more other such documents, such combination being obvious to a person skilled in the art <br> "&"    document member of the same patent family |

| Date of the actual completion of the international search <br> 08 March, 2007 (08.03.07) | Date of mailing of the international search report <br> 20 March, 2007 (20.03.07) |
|---|---|
| Name and mailing address of the ISA/ <br>    Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2007/051315

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2006-5339 A  (JSR Corp.),<br>05 January, 2006 (05.01.06),<br>Par. Nos. [0029] to [0032]<br>& US 2005/0260929 A1 | 4,7 |
| Y | JP 2000-301449 A  (Okamoto Machine Tool Works, Ltd.),<br>31 October, 2000 (31.10.00),<br>Par. Nos. [0016] to [0020]<br>(Family: none) | 8 |
| A | Microfilm of the specification and drawings annexed to the request of Japanese Utility Model Application No. 167053/1986(Laid-open No. 74267/1988)<br>(Kyocera Corp.),<br>18 May, 1988 (18.05.88),<br>Full text<br>(Family: none) | 1-8 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11070463 A
- JP 8216029 A
- JP 8500622 A
- JP 2000034416 A